# EUROPEAN PATENT APPLICATION

(11) **EP 4 163 424 A1**
(43) Date of publication of application: **12.04.2023**
(21) Application number: 21822039.0
(22) Date of filing: 12.04.2021
(51) Int. Cl.: C30B 25/18, H01L 21/02, H01L 21/205, C30B 29/38, C23C 16/34

(54) **SUBSTRATE FOR GROUP-III NITRIDE EPITAXIAL GROWTH AND METHOD FOR PRODUCING THE SAME**

(30) Priority: 09.06.2020 JP 2020100528; 15.12.2020 JP 2020207624
(71) Applicant: Shin-Etsu Chemical Co., Ltd., Tokyo 100-0005 (JP); Shin-Etsu Handotai Co., Ltd., Tokyo 100-0004 (JP)
(72) Inventor: KUBOTA, Yoshihiro, Annaka-shi, Gunma 379-0195 (JP); KAWAHARA, Minoru, Tokyo 100-0005 (JP); YAMADA, Masato, Tokyo 100-0004 (JP)
(74) Representative: Vossius & Partner Patentanwälte Rechtsanwälte mbB
(86) International application number: PCT/JP2021/015123
(87) International publication number: WO 2021/250991

(57) **Abstract**

A substrate for group III nitride epitaxial growth and a method for producing the same are provided, which are capable of fabricating a high-quality group III nitride single crystal at low cost. The substrate for group III nitride epitaxial growth according to the present invention includes: a supporting substrate having a structure in which a core consisting of nitride ceramics is wrapped in an encapsulating layer having a thickness of between 0.05 µm and 1.5 um, inclusive; a planarizing layer provided on an upper surface of the supporting substrate, the planarizing layer having a thickness of between 0.5 um and 3.0 um, inclusive; and a seed crystal layer consisting of a single crystal of a group III nitride, the seed crystal layer being provided on an upper surface of the planarizing layer and having a thickness of between 0.1 µm and 1.5 µm, inclusive.

## Description

### TECHNICAL FIELD

The present invention relates to seed substrates used for epitaxial growth of single crystals of group III nitrides, such as aluminum nitride (AlN), aluminum gallium nitride (AlₓGa₁₋ₓN (however, 0 < x < 1.0)), and gallium nitride (GaN).

### BACKGROUND ART

Substrates of group III nitrides, such as crystalline AlN and GaN, have a wide bandgap, and possess short wavelength luminescence, high breakdown voltage, and excellent high frequency characteristics. For this reason, group III nitride substrates are expected to be applied to devices such as light-emitting diodes (LEDs), lasers, Schottky diodes, power devices, and high-frequency devices. In particular, bactericidal effects have been reported in the emission wavelength in the deep ultraviolet range (UVC; 200 to 280 nm) of LEDs fabricated from single crystals of AlN and AlₓGa₁₋ₓN (0.5 < x < 1.0) (Non-Patent Document 1), and further improvement in quality, increase in diameter, and reduction in cost, are desired.

Since AlN does not have a melting point under normal pressure, the production with the melt method commonly used for silicon single crystals, or the like, is difficult.

Non-Patent Documents 2 and 3 describe a method of producing an AlN single crystal substrate by using a sublimation method (improved Rayleigh method) using SiC or AlN as seed crystals in an N₂ atmosphere at 1700 to 2250°C. However, due to equipment limitations, such as high temperature requirements for crystal growth, it is difficult to reduce the cost, and it is also difficult to achieve a large diameter of ϕ 4 inches or more.

Patent Document 1 describes a method for growing an AlN layer by using an hydride vapor deposition (HVPE) method using a sapphire substrate or an AlN substrate as a base substrate. However, it is difficult to reduce the dislocation density of the AlN layer due to the difference in lattice constant when sapphire is used for the base substrate. On the other hand, using an AlN substrate obtained by using the sublimation method as a base substrate reduces dislocation density, but it is difficult to reduce cost because the base substrate itself is expensive.

Meanwhile, Patent Document 2 describes a method of epitaxially growing group III nitrides, such as GaN single crystals, on a composite substrate on which a silicon <111> single crystal is transferred after encapsulating inexpensive AlN ceramics with Si₃N₄, or the like. However, when epitaxial deposition is performed on a single crystal of, for example, AlN or AlₓGa₁₋ₓN (0 < x < 1) using this method, it is difficult to reduce the dislocation density and it is also difficult to reduce the warpage of the substrate. These factors affect the degradation of properties and lower yields in device fabrication in the downstream process, and have consequently hindered improvement in quality and cost reduction of LEDs to be fabricated.

Hence, in order to eliminate such shortcomings, the inventors and the like have diligently conducted examinations and come to the present invention.

### PRIOR ART REFERENCES

### PATENT DOCUMENTS

Patent Document 1: JP6042545B
Patent Document 2: JP6626607B

### NON-PATENT DOCUMENTS

Non-Patent Document 1: LEDs Magazine Japan; December 2016, pp. 30-31
Non-Patent Document 2: SEI Technical Review; No. 177, pp. 88-91
Non-Patent Document 3: Fujikura Technical Review; No. 119, 2010, Vol. 2, pp. 33-38

### SUMMARY OF THE INVENTION

### PROBLEMS TO BE SOLVED BY THE INVENTION

The present invention has been made in light of the above circumstances, and an object thereof is to provide a substrate for group III nitride epitaxial growth that is capable of fabricating single crystals of group III nitrides, in particular, AlN or AlₓGa₁₋ₓN (0.5 < x < 1.0), with high quality and at low cost, which are suitable for use in light-emitting diodes in the deep ultraviolet range (UVC; 200 to 280 nm), and a method for producing the same.

### MEANS FOR SOLVING THE PROBLEMS

In order to solve the above-described problems, a substrate for group III nitride epitaxial growth according to an embodiment of the present invention includes: a supporting substrate having a structure in which a core consisting of nitride ceramics is wrapped in an encapsulating layer having a thickness of between 0.05 µm and 1.5 µm, inclusive; a first planarizing layer provided on an upper surface of the supporting substrate, the first planarizing layer having a thickness of between 0.5 µm and 3.0 µm, inclusive; and a seed crystal layer consisting of a single crystal of a group III nitride, the seed crystal layer being provided on an upper surface of the first planarizing layer and having a thickness of between 0.1 um and 1.5 µm, inclusive.

In addition, a substrate for group III nitride epitaxial growth according to another embodiment of the present invention includes: a supporting substrate having a structure in which a core consisting of nitride ceramics is wrapped in an encapsulating layer having a thickness of between 0.05 um and 1.5 um, inclusive; a first planarizing layer provided on an upper surface of the supporting substrate, the first planarizing layer having a thickness of between 0.5 um and 3.0 µm, inclusive; a second planarizing layer provided on an upper surface of the first planarizing layer, the second planarizing layer having a thickness of between 0.5 µm or less; and a seed crystal layer consisting of a single crystal of a group III nitride, the seed crystal layer being provided on an upper surface of the second planarizing layer and having a thickness of between 0.1 µm and 1.5 um, inclusive. Here, the second planarizing layer may contain any one of silicon oxide, silicon oxynitride, and aluminum arsenide.

In the present invention, a substrate for group III nitride epitaxial growth may further include a stress adjusting layer on a bottom surface of the supporting substrate.

In the present invention, the core may be aluminum nitride ceramics. In addition, the encapsulating layer may contain silicon nitride. In addition, the first planarizing layer may contain any one of a silicon oxide, a silicon oxynitride, and an aluminum arsenide. In addition, the stress adjusting layer may contain simple substance silicon.

In the present invention, the seed crystal layer may be aluminum nitride or aluminum gallium nitride. The light transmissibility of the seed crystal layer at a wavelength of 230 nm is preferably 70% or more. In addition, the resistivity of the seed crystal layer is preferably 1 × 10⁶ Ωcm or more.

In addition, a method for producing a substrate for group III nitride epitaxial growth according to an embodiment of the present invention includes the steps of: preparing a core consisting of nitride ceramics; obtaining a supporting substrate by depositing an encapsulating layer so as to wrap the core, the encapsulating layer having a thickness of between 0.05 um and 1.5 µm, inclusive; depositing a first planarizing layer on an upper surface of the supporting substrate, the first planarizing layer having a thickness of between 0.5 um and 3.0 um, inclusive; and providing a seed crystal layer consisting of a single crystal of a group III nitride on an upper surface of the first planarizing layer, the seed crystal layer having a thickness of between 0.1 um and 1.5 µm, inclusive.

A method for producing a substrate for group III nitride epitaxial growth according to another embodiment of the present invention includes the steps of: preparing a core consisting of nitride ceramics; obtaining a supporting substrate by depositing an encapsulating layer so as to wrap the core, the encapsulating layer having a thickness of between 0.05 µm and 1.5 µm, inclusive; depositing a first planarizing layer on an upper surface of the supporting substrate, the first planarizing layer having a thickness of between 0.5 µm and 3.0 µm, inclusive; and preparing a single crystal substrate of a group III nitride, one surface of the single crystal substrate being an ion implantation surface; forming a peeling position in the single crystal substrate by performing ion implantation from the ion implantation surface; prior to or after the step of forming the peeling position, depositing a second planarizing layer on an upper surface of the ion implantation surface of the single crystal substrate, the second planarizing layer having a thickness of 0.5 um or less; obtaining a bonded substrate by bonding the second planarizing layer and the first planarizing layer; and forming a seed crystal layer consisting of a single crystal of a group III nitride by separating the bonded substrate at the peeling position to remove a remaining section of the single crystal substrate, the seed crystal layer having a thickness of between 0.1 µm and 1.5 um, inclusive. Here, the second planarizing layer may be deposited by using any one of a plasma CVD method, an LPCVD method, and a low-pressure MOCVD method. In addition, the second planarizing layer may contain any one of silicon oxide, silicon oxynitride, and aluminum arsenide.

In the present invention, the method for producing a substrate for group III nitride epitaxial growth may further include a step of depositing a stress adjusting layer on a bottom surface of the supporting substrate.

In the present invention, the encapsulating layer may be deposited by using an LPCVD method. In addition, the first planarizing layer may be deposited by using any one of a plasma CVD method, an LPCVD method, and a low-pressure MOCVD method.

In the present invention, the step of providing a seed crystal layer may include the steps of: preparing a single crystal substrate of a group III nitride, one surface of the single crystal substrate being an ion implantation surface; forming a peeling position in the single crystal substrate by performing ion implantation from the ion implantation surface; obtaining a bonded substrate by bonding the ion implantation surface and the first planarizing layer; and separating the bonded substrate into the seed crystal layer and a remaining section of the single crystal substrate at the peeling position.

In the present invention, in the step of preparing a single crystal substrate, the single crystal substrate may be fabricated by using a sublimation method.

Alternatively, in the step of preparing a single crystal substrate, the single crystal substrate may be obtained by epitaxially growing an epitaxial layer on a base substrate by using any one of an MOCVD method, an HVPE method, and a THVPE method. In this case, the base substrate may be fabricated by using a sublimation method. In addition, in the step of forming a peeling position, the peeling position may be formed within the epitaxial layer. In addition, the remaining section of the single crystal substrate may be reused as a base substrate. Alternatively, the remaining section of the single crystal substrate may be reused as a single crystal substrate in production of a further different group III nitride composite substrate.

In the present invention, the core may be aluminum nitride ceramics. In addition, the encapsulating layer may contain silicon nitride. In addition, the first planarizing layer may contain any one of silicon oxide, silicon oxynitride, and aluminum arsenide. In addition, the stress adjusting layer may contain simple substance silicon.

In the present invention, the seed crystal layer may be aluminum nitride or aluminum gallium nitride. The light transmissibility of the seed crystal layer at a wavelength of 230 nm is preferably 70% or more. In addition, the resistivity of the seed crystal layer is preferably 1 × 10⁶ Ωcm or more.

### EFFECT OF THE INVENTION

According to the present invention, a substrate for group III nitride epitaxial growth, which is capable of fabricating a high-quality group III nitride single crystal, can be provided at low cost.

### BRIEF DESCRIPTION OF THE DRAWINGS

FIG. 1 is a diagram showing the cross-sectional structure of a composite substrate 1.
FIG. 2 is a diagram showing the procedure for producing the composite substrate 1.
FIG. 3 is a schematic diagram showing a substrate fabricated by using a sublimation method, the substrate being used as a single-crystal substrate 20.
FIG. 4 is a schematic diagram showing the structure of a single-crystal epitaxial layer substrate used as the single-crystal substrate 20.
FIG. 5 is a diagram showing the cross-sectional structure of a composite substrate 1A.
FIG. 6 is a diagram showing the procedure for producing the composite substrate 1A.

### EMBODIMENTS OF THE INVENTION

The embodiments of the present invention will be described in detail hereinafter, but the present invention is not limited thereto.

### First Embodiment

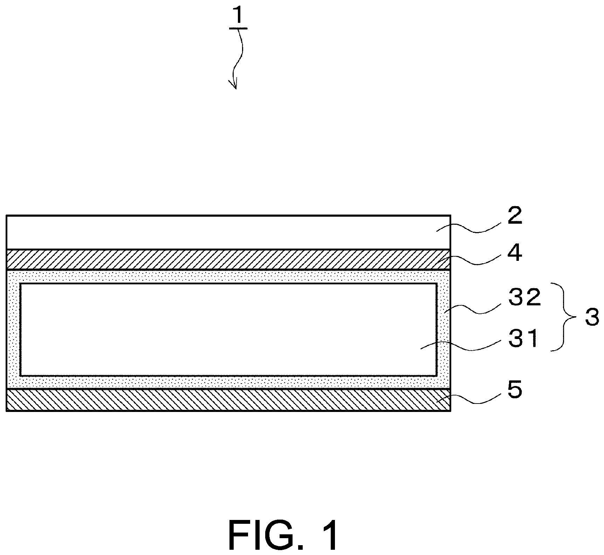

FIG. 1 shows the cross-sectional structure of a composite substrate 1 according to a first embodiment of the present invention. The composite substrate 1 shown in FIG. 1 has a structure in which a first planarizing layer 4 and a seed crystal layer 2 consisting of a single crystal of a group III nitride are laminated on a supporting substrate 3. In addition, if necessary, a stress adjusting layer 5 is provided on the surface (bottom surface) of the supporting substrate 3 opposite the surface on which the first planarizing layer 4 is laminated.

The supporting substrate 3 has a core 31 serving as the core material of the supporting substrate 3, and an encapsulating layer 32 covering the core 31.

Preferable materials for the core 31 include nitride ceramics, which have excellent heat resistance and stability and are available in large diameter sizes at low cost. Aluminum nitride (AlN), silicon nitride (Si₃N₄), gallium nitride (GaN), boron nitride (BN), or a mixture of these may be used as the nitride ceramics. AlN is particularly preferable because the lattice constant and coefficient of thermal expansion are close to those of a target group III nitride crystal, making it possible to fabricate a high-quality group III nitride crystal with less deformation. AlN is also preferable because it has high thermal conductivity and is superior in heat transfer in the downstream process, including heating.

The shape and size of the core 31 are preferably configured as a wafer shape with a thickness of 200 to 1000 um so that it may be included in a regular semiconductor process line. In addition, the surface of the core 31 is preferably mirror finished so that the asperities of the surface of the supporting substrate 3 may be reduced.

When AlN is used as the core 31, AlN ceramics may be produced in a variety of ways, but it is preferable to use the so-called sheet molding/atmospheric sintering method in which a wafer-like green sheet is fabricated by mixing AlN powder with a sintering agent, an organic binder, a solvent, and the like, and, following the degreasing, the sheet may be sintered and polished under an N₂ atmosphere, with respect to the point that a higher productivity may be achieved. The sintering agent may be selected from Y₂O₃, Al²O₃, CaO, and the like, but it is preferable to include, in particular, Y₂O₃ as a sintering agent, because the thermal conductivity of the substrate after sintering is high.

The encapsulating layer 32 is a layer that wraps and encapsulates the entire core without any gaps, and has a thickness of between 0.05 um and 1.5 µm, inclusive. Such structure may prevent substances originating from the ceramics material of the core 31 from leaking to the exterior of the supporting substrate 3.

For example, if AlN ceramics are used as the core 31, elemental substances originating from AlN and Y₂O₃ (which is added as the sintering agent), or substances incorporated into ceramics as impurities from insulation materials, furnace materials, containers, and the like, used for sintering ceramics may leak out. When such substances leak out of the supporting substrate 3, it is likely that they are incorporated as impurities during the epitaxial growth of the target AlN, and become a factor that degrades the quality.

If the thickness of the encapsulating layer 32 is thick, it becomes impossible to withstand the thermal stress between the surface layer and the interior of the encapsulating layer 32 after repeated heating and cooling in the downstream process, and peeling is likely to occur. Therefore, various films may be selected and combined, but it is not desirable if the thickness of the encapsulating layer 32 exceeds 1.5 µm. On the other hand, a thickness of less than 0.05 um is not sufficient in order to achieve a function of encapsulating substances originating from the core 31. From the above, the thickness of the encapsulating layer 32 is preferably between 0.05 µm and 1.5 µm, inclusive. A film made of silicon nitride (Si₃N₄) is preferable for the material of the encapsulating layer 32 because it has a high effect of encapsulating material substances originating from nitride ceramics.

The encapsulating layer 32 is preferably a dense film because of a higher encapsulation performance. In addition, the encapsulating layer 32 is preferably a film with high purity without any impurities, such as sintering agents. In this way, the encapsulating layer 32 is preferably suppressed from unintended substances originating from the encapsulating layer 32 itself leaking out of the supporting substrate 3.

These high-purity films may be deposited using a deposition method including an MOCVD method, an atmospheric CVD, an LPCVD (low-pressure CVD), and a sputtering method. In particular, the LPCVD method is preferably used because it can form a dense film and has excellent film coverage.

In addition, when silicon nitride is used as a material for the encapsulating layer 32, a film of silicon oxide (SiO₂), silicon oxynitride (SiₓO_{y}N_{z}), or the like, may be provided between the encapsulating layer and the core 31 as part of the encapsulating layer in order to improve adhesion between silicon nitride and the core. However, even in this case, in order to avoid peeling, it is preferable to set the total thickness of the encapsulating layer 32 between 0.05 µm and 1.5 um, inclusive.

The first planarizing layer 4 with a thickness of between 0.5 µm and 3.0 um, inclusive, is laminated on the encapsulating layer 32 at the upper surface of the supporting substrate 3. By laminating the first planarizing layer 4, various voids and asperities caused by the core 31, the encapsulating layer 32, or the like, can be filled, and a sufficient smoothness can be obtained for the seed crystal to be transferred. However, if the thickness of the first planarizing layer 4 is too thick, it will cause warpage, and the like, and this is not desirable. For this reason, the thickness of the first planarizing layer 4 is preferably between 0.5 and 3.0 um. That is, if the thickness of the first planarizing layer 4 is less than 0.5 µm, it is not desirable because voids and asperities generated in the supporting substrate 3 cannot be sufficiently filled. If the thickness of the first planarizing layer 4 is 3.0 µm or more, warpage is likely to occur, and so this is not desirable.

A stress adjusting layer 5 is provided on the surface (bottom surface) of the supporting substrate 3 opposite the upper surface on which the first planarizing layer 4 is laminated. The stress adjusting layer 5 cancels the stress generated by laminating the first planarizing layer 4 and reduces warpage.

In addition, the first planarizing layer 4 only needs to be laminated on one surface (upper surface) on the side of the supporting substrate 3, on which the seed crystal layer 2 is to be laminated, but it may be deposited on both surfaces (top and bottom surfaces) of the supporting substrate or may be deposited so as to cover the entire supporting substrate. In this way, the material laminated on the bottom surface acts as a stress adjusting layer 5, and the stress caused by the first planarizing layer 4 at the top and bottom of the substrate is structurally canceled, thereby further reducing the warpage of the substrate.

In addition, simple substance silicon (e.g., polycrystalline silicon) may be laminated as the stress adjusting layer 5. In this way, there is an advantage of realizing a composite substrate that is compatible with adsorption and desorption by an electrostatic chuck.

The material of the first planarizing layer 4 may be selected from silicon oxide (SiO₂), aluminum oxide (Al₂O₃), silicon nitride (Si₃N₄), silicon carbide (SiC) or silicon oxynitride (SiₓO_{y}N_{z}), silicon (Si), gallium arsenide (GaAs), aluminum arsenide (AlAs), and the like. In particular, silicon oxide (SiO₂), silicon oxynitride (SiₓO_{y}N_{z}), and aluminum arsenide (AlAs) are preferable because they are easy to grind and polish when planarizing, and they can easily become a sacrificial layer for separating the supporting substrate 3 after epitaxial growth of the target group III nitride such as AlN.

The deposition of the first planarizing layer 4 may be arbitrarily selected, depending on the required film quality and deposition efficiency, from a plasma CVD method or LPCVD method, a low-pressure MOCVD method, or the like. Depending on the condition of the laminated first planarizing layer 4 film, heat treatment of baking and CMP polishing may be applied after deposition in order to prepare for the formation of the seed crystal layer 2.

The seed crystal layer 2 consisting of a single crystal of a group III nitride is formed on the first planarizing layer 4 formed on the upper surface of the supporting substrate 3. The seed crystal layer 2 may be formed by being peeled off from a high-quality group III nitride single crystal. The thickness of the seed crystal layer 2 is preferably between 0.1 µm and 1.5 µm, inclusive. In this way, a high-quality seed crystal layer 2 can be formed. More specifically, ion implantation peeling may be applied to a group III nitride single crystal substrate in order to transfer a high-quality crystal layer. If the thickness of the seed crystal layer 2 is less than 0.1 µm, the thickness of the layer damaged during ion implantation is substantially close to the thickness of the seed crystal layer, so such seed crystal layer cannot be a good seed crystal. If the thickness of the seed crystal layer 2 is 1.5 µm or more, the ion implantation equipment becomes huge and requires enormous investment, thereby making it impractical.

The high-quality group III nitride single crystal used in this case is preferably a single crystal epitaxially grown by using any of a sublimation method, an MOCVD (metal-organic chemical vapor deposition) method, an HVPE (hydride vapor phase epitaxy) method, and a THVPE (trihalide vapor phase epitaxy) method. In addition, it is preferably a crystal with an extremely low dislocation density, with the EPD of such single crystal being 1 × 106 cm⁻² or less.

The composition of the seed crystal layer 2 preferably matches the composition of the target film to be epitaxially grown. For example, the composition of the seed crystal layer 2 may preferably be aluminum nitride (AlN) or aluminum gallium nitride (AlₓGa₁₋ₓN (0.5 < x < 1.0)), which is the preferred material for light-emitting diodes in the deep ultraviolet range (UVC; 200 to 280 nm).

When the target epitaxial film is used in optical elements, such as light-emitting diodes, the grown epitaxial film may be removed together with the seed crystal layer 2 and processed into and utilized as a device by increasing the transparency of the seed crystal layer 2. For example, when used in optical elements in the deep ultraviolet range, the light transmissibility of the seed crystal layer 2 is preferably 70% or more at a wavelength of 230 nm, more preferably 90% or more, and even more preferably 95% or more.

In addition, the resistivity of the seed crystal layer 2 is preferably 1 × 10⁶ Ωcm or more. In this way, impurities incorporated into the target material epitaxially deposited on the seed crystal layer 2 may be reduced, and coloring (i.e., light absorption) of the target material may be suppressed.

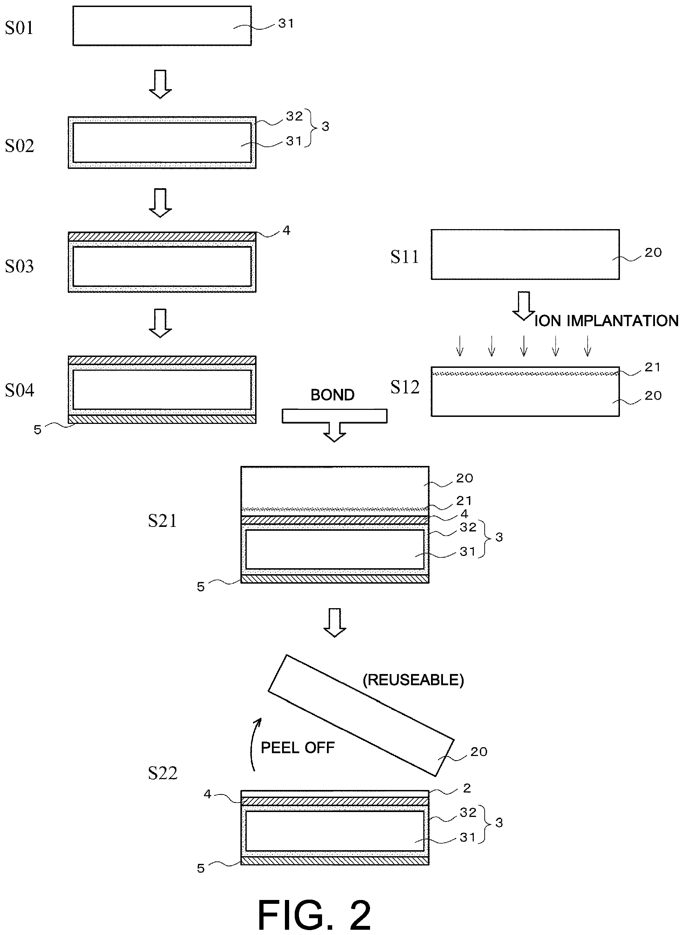

Then, with reference to FIG. 2, the procedure for producing the substrate for group III nitride epitaxial growth according to the first embodiment of the present invention will be described. First, the core 31 consisting of nitride ceramics is prepared (S01 in FIG. 2). Next, the encapsulating layer 32 with a thickness of between 0.05 um and 1.5 µm, inclusive, is deposited so as to wrap in the core 31 and the supporting substrate 3 is obtained (S02 in FIG. 2). In this case, the encapsulating layer 32 may be deposited by using an LPCVD method.

Next, the first planarizing layer 4 with a thickness of between 0.5 µm and 3.0 um, inclusive, is deposited on the upper surface of the supporting substrate 3 (S03 in FIG. 2). The first planarizing layer 4 may be deposited by using any one of the plasma CVD method, the LPCVD method, and the low-pressure MOCVD method. In addition, the stress adjusting layer 5 is further deposited on the bottom surface of the supporting substrate 3 (S04 in FIG. 2). The first planarizing layer 4 and the stress adjusting layer 5 may be deposited at the same time.

Apart from S01-S04, a group III nitride single crystal substrate 20 is prepared for peeling transfer of the seed crystal layer 2 (S11 in FIG. 2). The specific technique for preparing this single crystal substrate 20 will be described later. Next, ion implantation is performed from one surface (ion implantation surface) of the single crystal substrate 20, and a peeling position (embrittlement layer) 21 is formed in the single crystal substrate 20 (S12 in FIG. 2). The ions to be implanted are, for example, H⁺, H₂⁺, Ar⁺, He⁺, and the like.

Next, the ion implantation surface of the single crystal substrate 20 is bonded to the first planarizing layer 4 formed on the supporting substrate 3 to obtain a bonded substrate (S21 in FIG. 2). Then, the single crystal substrate 20 is separated at the peeling position 21 of the single crystal substrate 20 in the bonded substrate (S22 in FIG. 2). In this way, a group III nitride single crystal film is transferred as a seed crystal layer 2 onto the first planarizing layer 4 on the supporting substrate 3, and a group III nitride composite substrate in which the supporting substrate 3, the first planarizing layer 4, and the seed crystal layer 2 are laminated is obtained. On the other hand, the remaining section of the separated group III nitride single crystal substrate 20 can be repeatedly utilized for transferring a seed crystal layer when fabricating another group III nitride composite substrate by polishing the surface again to make an ion implantation surface.

The ion implantation surface of the group III nitride single crystal substrate 20 may be bonded once to a different temporary supporting substrate, such as a silicon wafer, and, after separation, the seed crystal layer 2 may be kept bonded to the temporary supporting substrate. After bonding the seed crystal layer 2 on this temporary supporting substrate to the first planarizing layer 4, the process of separating the temporary supporting substrate from the seed crystal layer may be performed. In this way, the seed crystal layer 2 bonded to the first planarizing layer 4 may be bonded upside down.

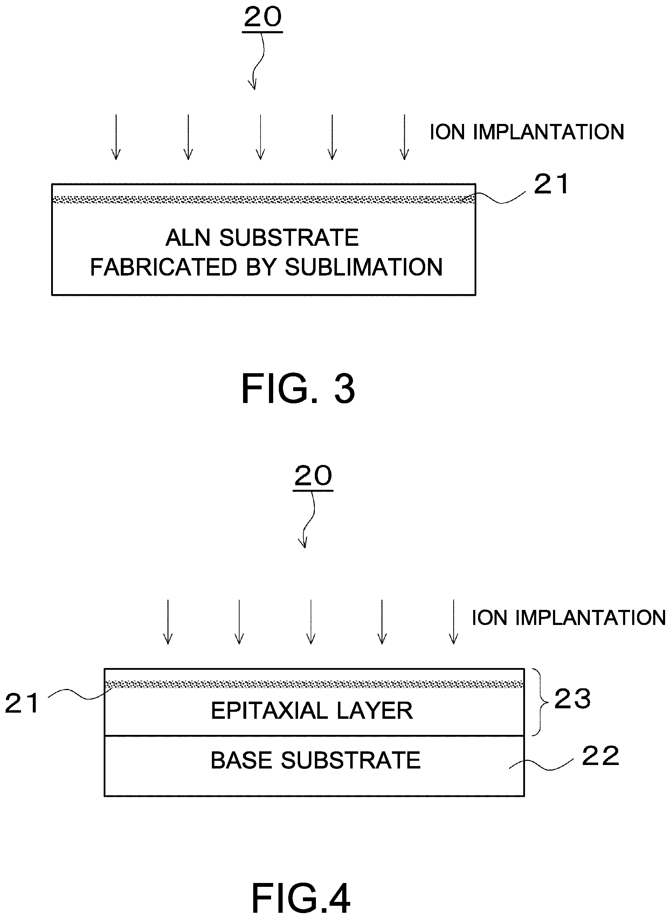

Next, the method of preparing a group III nitride single crystal substrate 20 will be described. The group III nitride single crystal substrate 20 may be fabricated by using a sublimation method. An AlN substrate fabricated by using the sublimation method is expensive, but as shown in FIG. 3, the cost of fabricating composite substrates can be significantly reduced because the remaining section of the single crystal substrate remained after the performance of the transfer with a thickness of between 0.1 µm and 1.5 µm can be repeatedly used by reusing the same for the fabrication of the next composite substrate.

Alternatively, as shown in FIG. 4, a group III nitride single crystal epitaxial layer substrate may be used as the group III nitride single crystal substrate 20. The group III nitride single crystal epitaxial layer substrate is obtained by epitaxially depositing a group III nitride epitaxial layer 23 on the base substrate 22 by using any of the methods including the MOCVD method, the HVPE method, and the THVPE method. In this case, a group III nitride single crystal substrate (e.g., AlN substrate) fabricated by using the sublimation method may be used for the base substrate 22. When using a single crystal epitaxial layer substrate, the peeling position 21 obtained by ion implantation may be set within the epitaxial layer 23. In this way, a seed crystal layer 2 can be formed without consuming the expensive AlN substrate fabricated by using the sublimation method, thereby reducing the production cost. In addition, when epitaxially depositing an AlₓGa₁₋ₓN single crystal by using any of the methods including the MOCVD method, the HVPE method, and the THVPE method, there is an advantage to the effect that an optimum value for epitaxial growth in the target downstream process can be selected because the value of x of AlₓGa₁₋ₓN may be varied between 0 ≤ x ≤ 1 by adjusting the source gas composition, and the like.

Further, if the peeling position is set within the epitaxial layer, the remaining section of the single crystal epitaxial layer substrate remained after the performance of the transfer with a thickness of between 0.1 µm and 1.5 um may be reused for fabricating the next composite substrate. In this way, the single crystal epitaxial layer substrate can be used repeatedly, thereby significantly reducing the cost for fabricating composite substrates. In addition, if an epitaxial layer is regenerated by using, as a base substrate, the remaining section of the single crystal epitaxial layer substrate having a thinned-out epitaxial layer portion as a result of repeated use, and by epitaxially depositing a group III nitride epitaxial layer by using any of the methods including the MOCVD method, the HVPE method, and the THVPE method, the initial substrate can be used repeatedly, thereby further reducing the fabrication cost.

### Second Embodiment

Next, the second embodiment of the present invention will be described. The feature of the composite substrate 1A according to the present embodiment lies in the point that it has a second planarizing layer 24 in addition to the first planarizing layer 4 in the first embodiment. For the rest, the features are similar to those of the first embodiment described above. The same references will be used for the parts common to the first embodiment, and the description thereof will be omitted.

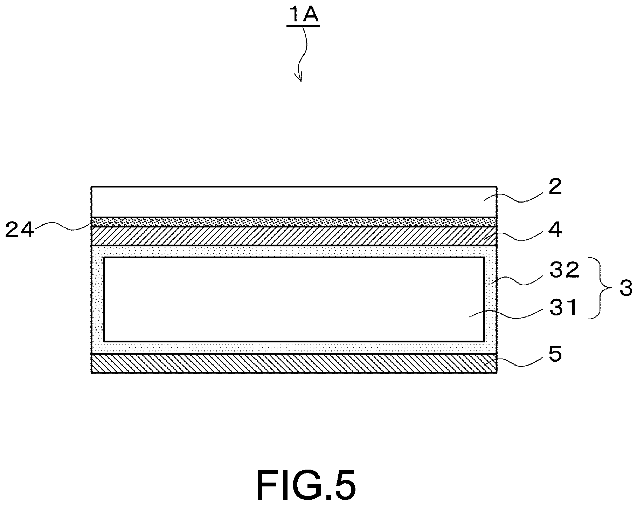

FIG. 5 shows the cross-sectional structure of the composite substrate 1A according to the second embodiment. The composite substrate 1A shown in FIG. 5 has a structure in which the first planarizing layer 4, the second planarizing layer 24, and the seed crystal layer 2 consisting of a single crystal of a group III nitride are laminated on the supporting substrate 3. In addition, if necessary, the stress adjusting layer 5 is provided on the surface (bottom surface) of the supporting substrate 3 opposite the surface on which the first planarizing layer 4 is laminated.

In the second embodiment, the supporting substrate 3, the first planarizing layer 4, and the stress adjusting layer 5 are similar to those of the first embodiment. The second planarizing layer 24 and the seed crystal layer 2 consisting of a single crystal of a group III nitride are formed on the first planarizing layer 4 formed on the upper surface of the supporting substrate 3. As with the first embodiment, the seed crystal layer 2 may be formed by being peeled off from a high-quality group III nitride single crystal.

The material of the second planarizing layer 24 may be selected from silicon oxide (SiO₂), aluminum oxide (Al₂O₃), silicon nitride (Si₃N₄), silicon carbide (SiC) or silicon oxynitride (SiₓO_{y}N_{z}), silicon (Si), gallium arsenide (GaAs), aluminum arsenide (AlAs), and the like. The film thickness of the second planarizing layer 24 may be 500 nm (0.5 um) or less.

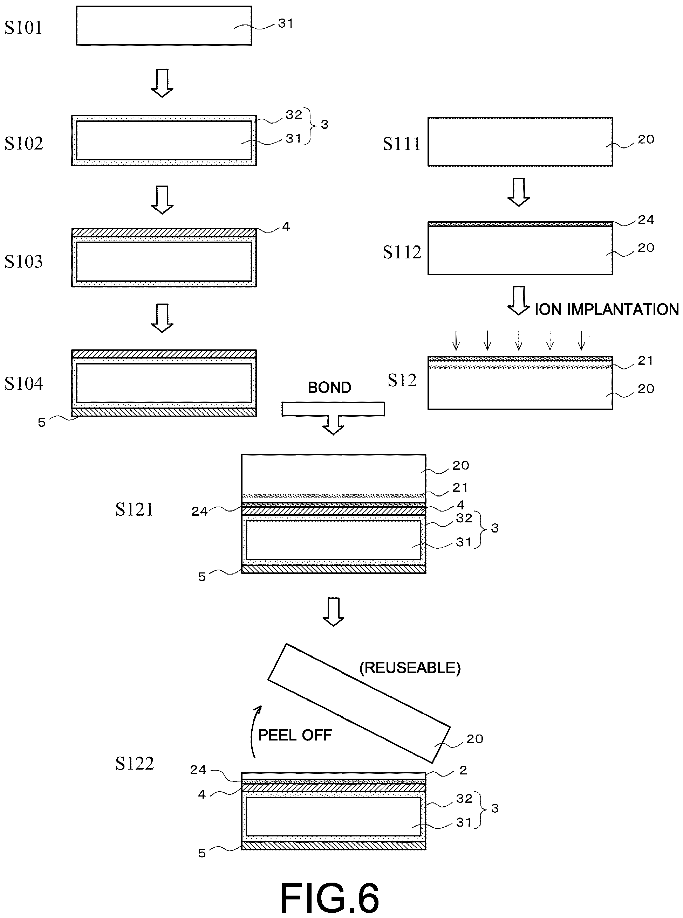

Then, with reference to FIG. 6, the procedure for producing the substrate for group III nitride epitaxial growth according to the second embodiment of the present invention will be described. First, the core 31 consisting of nitride ceramics is prepared (S101 in FIG. 6). Next, the encapsulating layer 32 with a thickness of between 0.05 um and 1.5 µm, inclusive, is deposited so as to wrap in the core 31 and the supporting substrate 3 is obtained (S102 in FIG. 6). In this case, the encapsulating layer 32 may be deposited by using an LPCVD method.

Next, the first planarizing layer 4 with a thickness of between 0.5 µm and 3.0 µm, inclusive, is deposited on the upper surface of the supporting substrate 3 (S103 in FIG. 6). The first planarizing layer 4 may be deposited by using any one of the plasma CVD method, the LPCVD method, and the low-pressure MOCVD method. In addition, the stress adjusting layer 5 is further deposited on the bottom surface of the supporting substrate 3 (S104 in FIG. 6). The first planarizing layer 4 and the stress adjusting layer 5 may be deposited at the same time.

Apart from S101-S104, a group III nitride single crystal substrate 20 is prepared for peeling transfer of the seed crystal layer 2 (Sill in FIG. 6). The specific technique for preparing this single crystal substrate 20 is similar to that used in the first embodiment. Next, the second planarizing layer 24 with a thickness of 0.5 µm or less is deposited on one surface of the single crystal substrate 20 (S112 in FIG. 6). The second planarizing layer 24 may be deposited by using any one of the plasma CVD method, the LPCVD method, and the low-pressure MOCVD method.

Next, ion implantation is performed from the surface (ion implantation surface) of the single crystal substrate 20, on which the second planarizing layer 24 is formed, and the peeling position (embrittlement layer) 21 is formed in the single crystal substrate 20 (S113 in FIG. 6). The ions to be implanted are, for example, H⁺, H₂⁺, Ar⁺, He⁺, and the like.

Next, the second planarizing layer 24 formed on the single crystal substrate 20 is bonded to the first planarizing layer 4 formed on the supporting substrate 3 to obtain a bonded substrate (S121 in FIG. 6). Then, the single crystal substrate 20 is separated at the peeling position 21 of the single crystal substrate 20 in the bonded substrate (S122 in FIG. 2). In this way, the second planarizing layer 24 and the seed crystal layer 2, which is a group III nitride single crystal film, are transferred onto the first planarizing layer 4 on the supporting substrate 3, and a group III nitride composite substrate in which the supporting substrate 3, the first planarizing layer 4, the second planarizing layer 24, and the seed crystal layer 2 are laminated is obtained. On the other hand, the remaining section of the separated group III nitride single crystal substrate 20 can be repeatedly utilized for transferring a seed crystal layer when fabricating another group III nitride composite substrate by polishing the surface again to make an ion implantation surface. The deposition of the second planarizing layer 24 (step S112) may be performed after the process of ion implanting into the single crystal substrate 20 (step S113), but it is preferably performed before ion implantation in consideration of the uniformity of ion implantation.

The composite substrate 1A according to the second embodiment has the second planarizing layer 24 in addition to the first planarizing layer 4 as described above, and the boundary between the first planarizing layer 4 and the second planarizing layer 24 becomes the bonded interface. Such a configuration provides, in addition to the same effect as the composite substrate 1 in the first embodiment, an enhancement of the bond strength between the supporting substrate 3 and the seed crystal layer.

### EXAMPLES

The present invention will be described more specifically hereinafter by citing examples and comparative examples below, but the present invention is not limited to these examples.

### Example 1

### (Preparation of Supporting Substrate)

(1) An AlN polycrystalline ceramics substrate, which is polished on both surfaces and has a diameter (ϕ) of 2 inches and a thickness (t) of 300 um, was used as the core. Such substrate was obtained by mixing 100 parts by weight of AlN powder and 5 parts by weight of Y₂O₃ (a sintering agent) with an organic binder, a solvent, and the like, to create a green sheet, and, following the degreasing, sintering the sheet under an atmosphere of N₂ at a temperature of 1900°C. (2) A supporting substrate was obtained by wrapping in the entire AlN ceramics core with a 0.1 µm thick silicon oxynitride layer by using the LPCVD method, wrapping, on top thereof, the entire thing with a 0.4 um thick silicon nitride (Si₃N₄) layer using further different LPCVD equipment, and encapsulating the entire thing (the total thickness of the encapsulating layer is 0.5 µm).

### (Lamination of First Planarizing Layer)

For the purpose of planarization, a 6 µm thick SiO₂ was further laminated on the Si₃N₄ layer on one surface (upper surface) of the supporting substrate by using the plasma CVD method (ICP-CVD equipment). After that, the first planarizing layer having a surface roughness of Ra = 0.2 nm was obtained by polishing and planarizing the SiO₂ to a thickness of 2 µm by CMP polishing after baking the SiO₂ at 1000°C.

### Preparation of Seed Crystal

An AlN crystal used as a seed crystal was created by using a sublimation method (improved Rayleigh method) according to the following procedure. First, a TAC crucible was placed in a high purified graphite growth container, a high-purity AlN raw material was provided at the bottom of the TAC crucible, and an AlN crystal was provided at the top. The growth container and the crucible were heated by high-frequency induction heating, the raw material was kept at 2000°C, the raw material was decomposed through sublimation, and AlN single crystals were precipitated on the AlN crystal at the top. This AlN single crystal was sliced and polished to form a smooth ϕ 2-inch substrate with a thickness of 200 µm. The resistivity was measured at eight equal spacing points on the surface of the substrate, and the resistivity was measured from 1 × 10⁶ Ωcm to 3 × 10¹¹ Ωcm. The light transmissibility of the 230 nm wavelength was 0.2% at a thickness of 100 µm.

### (Fabrication of Seed Crystal Layer)

Ion implantation of hydrogen was carried out on the AlN single crystal substrate at 100 keV, at a depth of 0.6 um (peeling position), and with a dose of 8 × 10¹⁷ cm⁻². The ion implantation surface of the AlN single crystal substrate after ion implantation was bonded with the first planarizing layer of the supporting substrate prepared earlier. After that, the seed crystal layer of the AlN single crystal was transferred to the supporting substrate by peeling and separation at the peeling position (section at 0.6 µm). The section of the AlN single crystal in the seed crystal layer, which was damaged during ion implantation and transfer, was lightly polished with CMP, and the thickness of the AlN crystal layer was set to 0.4 µm. The light transmissibility of the 230 nm wavelength of this seed crystal layer was 99.9%. It should be noted that, when measuring the light transmissibility of the seed crystal layer, it was not possible to measure the transmissibility while the seed crystal layer was still transferred on the supporting substrate because the supporting substrate was opaque. Therefore, the light transmissibility was separately confirmed by instead using a seed crystal layer transferred on a quartz substrate under the same conditions. The remaining section of the AlN single crystal substrate after the transfer (i.e., the section that was peeled and separated without being transferred to the supporting substrate) could be utilized as multiple seed crystals by repeatedly carrying out ion implantation, making it extremely economical. According to the present example, a substrate for AlN epitaxial growth was obtained, in which a 2 µm thick first planarizing layer and a 0.4 µm thick AlN seed crystal layer were provided on the supporting substrate having the structure of (1) an AlN ceramics core and (2) an encapsulating layer.

### (Evaluation of Substrate)

Next, the following simple evaluation regarding adequacy as a substrate for AlN epitaxial growth was further performed on the above-described substrate. More specifically, 2 µm of AlN was deposited on the substrate for AlN epitaxial growth using the MOCVD method, and in order to evaluate the dislocation density, the etch pit density (hereinafter referred to as "EPD") was measured by generating etch pitches by the molten alkali (KOH + NaOH) etching method. In addition, X-ray rocking curve (XRC) measurements were performed to evaluate the crystallinity. As a result, the EPD showed an extremely low dislocation density of 1.2 × 10⁴ cm⁻². The XRC measurements on a (0002) plane of the substrate yielded a half-value width FWHM of 187 arcsec, resulting in a high-quality AlN single crystal. These results indicate that the substrate for epitaxial growth according to the present example is superior.

### Comparative Example 1

As with Example 1, 2 µm of AlN was deposited on a ϕ 2-inch sapphire substrate using the MOCVD method. As a result, the EPD showed an extremely large dislocation density of 3.5 × 10¹⁰ cm⁻². In addition, the FWHM yielded in the XRC measurements on the (0002) plane of the substrate was 2300 arcsec, resulting in a low-quality AlN single crystal. It is considered that this is due to a significant difference in the lattice constant and coefficient of thermal expansion between sapphire and AlN.

### Comparative Example 2

A substrate (ϕ 2 inches x t 150 µm) of the AlN crystal fabricated by using the sublimation method (improved Rayleigh method) prepared in Example 1 was directly used as a base substrate that also served as a seed crystal. This seed crystal showed the light transmissibility of 0.2% for the 230 nm wavelength at a thickness of 100 um. As with Example 1, 2 um of AlN was deposited on such substrate using the MOCVD method. The resulting AlN substrate was significantly colored and the EPD was 2.5 × 10⁴ cm⁻². In addition, the FWHM yielded in the XRC measurements on the (0002) plane of the substrate was 300 arcsec, and thus the crystallinity level was substantially close to that of Example 1, but the coloring was intense, and the substrate was therefore unsuitable for use as a substrate for epitaxial growth for deep ultraviolet light. Example 1 was extremely economical because a number of thin film seed crystals could be utilized by using an inexpensive ceramics substrate as the base substrate and transferring an expensive AlN substrate obtained by using the sublimation method. However, it was difficult to reuse the extremely expensive substrate obtained through the sublimation method in the present example.

### Example 2

### (Preparation of Supporting Substrate)

An AlN polycrystalline ceramics substrate having (1) a core similar to that of Example 1 was used as the structure of a supporting substrate. Then, (2) as an encapsulating layer, the entire AlN ceramics core was first wrapped in with a 0.5 um thick SiO₂ layer by using the LPCVD method, and then, on top of which, the entire thing was encapsulated with a 0.8 µm thick Si₃N₄ layer using further different LPCVD equipment (the total thickness of the encapsulating layer was 1.3 µm) in order to form the supporting substrate.

### (Lamination of First Planarizing Layer and Stress Adjusting Layer)

For the purpose of planarization, a 6 µm thick SiO₂ was further laminated on the Si₃N₄ layer on one surface (upper surface) of the supporting substrate by using the plasma CVD method (ICP-CVD equipment). After that, the first planarizing layer having a surface roughness of Ra = 0.2 nm was obtained by polishing and planarizing the SiO₂ to a thickness of 2 µm by CMP polishing after baking the SiO₂ at 1000°C.

For the purpose of planarization, 4 µm of silicon oxynitride was further laminated on the Si₃N₄ layer on one surface (upper surface) of the supporting substrate by using the LPCVD method. After that, the silicon oxynitride layer was CMP polished to a thickness of 3 um. The entire substrate showed a warpage of about 30 um. In order to correct the warpage, silicon oxynitride was laminated on the bottom surface to a thickness of 5 µm by using the LPCVD method to obtain a stress adjusting layer. After that, 0.2 um of polycrystalline Si was further added by using the LPCVD method so as to be compatible with adsorption and desorption by an electrostatic chuck. As a result, the warpage was substantially eliminated.

### (Preparation of Seed Crystal)

On the AlN single crystal substrate created by using the sublimation method in Example 1, a single crystal of Al_{0.9}Ga_{0.1}N was epitaxially grown to a thickness of 500 µm by using AlCl₃, GaCl₃, and NH₃ as raw materials by the THVPE method. This single crystal of Al_{0.9}Ga_{0.1}N was cut from the AlN single crystal substrate with a wire saw. The Al_{0.9}Ga_{0.1}N single crystal was polished to form a smooth ϕ 2-inch substrate. In addition, this cut Al_{0.9}Ga_{0.1}N single crystal had no coloration, and the transmissibility of light at 230 nm wavelength was about 70% at a thickness of 100 µm, so the transmissibility and resistance were both extremely excellent. There was also no problem with adsorption and desorption of the substrate by an electrostatic chuck.

Ion implantation of hydrogen was carried out on the above-described Al_{0.9}Ga_{0.1}N single crystal substrate at 100 keV, at a depth of 1.8 µm, and with a dose of 5 × 10¹⁷ cm⁻². This Al_{0.9}Ga_{0.1}N single crystal substrate after ion implantation was transferred to the first planarizing layer of the supporting substrate prepared earlier. The peeling section at the top of the Al_{0.9}Ga_{0.1}N single crystal transferred to the supporting substrate was lightly polished with CMP. The thickness of the Al_{0.9}Ga_{0.1}N single crystal layer was set to 0.2 µm. The transmissibility of light of the 230 nm wavelength at this seed crystal layer was about 98%. When a large number of Al_{0.9}Ga_{0.1}N single crystals were transferred from the AlN base substrate obtained by using the sublimation method, and the thickness of the Al_{0.9}Ga_{0.1}N single crystal was reduced to close to the thickness of the remaining AlN single crystal substrate, the deposition of Al_{0.9}Ga_{0.1}N single crystal was repeated again using AlCl₃, GaCl₃, and NH₃ as raw materials by the THVPE method, and the use of the expensive AlN base substrate obtained by using the sublimation method was therefore enabled to be recycled. Thus, it was possible to utilize the Al_{0.9}Ga_{0.1}N single crystal at the top as a number of seed crystals by repeatedly carrying out ion implantation, and inexpensive and high-performance substrates were obtained to be used as a substrate for epitaxial growth for the deep ultraviolet range or a solid substrate.

Using a method similar to that of Example 1, a substrate for aluminum gallium nitride epitaxial growth suitable for the deep ultraviolet range was obtained, in which a 3 µm thick first planarizing layer and a 0.2 um thick Al_{0.9}Ga_{0.1}N seed crystal layer are provided on the supporting substrate having the structure of (1) an AlN ceramics core and (2) an encapsulating layer. The above-described thin-film transfer layer was transparent and no coloring was shown.

### (Evaluation of Substrate)

Next, the following simple evaluation regarding adequacy as a substrate for aluminum gallium nitride epitaxial growth was further performed on the above-described substrate. More specifically, 2 µm of Al_{0.9}Ga_{0.1}N was deposited on the substrate for aluminum gallium nitride epitaxial growth using the MOCVD method, and in order to evaluate the dislocation density similarly to the above, the EPD was measured by generating etch pitches by the molten alkali (KOH + NaOH) etching method. In addition, XRC measurements were performed to evaluate the crystallinity. As a result, the EPD showed an extremely low dislocation density of 0.5 × 10⁴ cm⁻². The XRC measurements on a (0002) plane of the substrate yielded a FWHM of 152 arcsec, resulting in a high-quality Al_{0.9}Ga_{0.1}N single crystal. As can be seen from these results, the substrate for epitaxial growth in the present example was as superior as that in Example 1.

### Comparative Example 3

The resistivity values of the AlN seed crystal substrate at eight equal spacing points on the surface measured 1 × 10⁵ Ωcm to 8 × 10⁵ Ωcm, and the substrate was significantly colored. The others were performed in exactly the same way as in Example 1.

As a result, a substrate for AlN epitaxial growth was obtained, in which a 2 um thick first planarizing layer and a 0.4 um thick AlN seed crystal layer were provided on the supporting substrate having the structure of (1) an AlN ceramics core and (2) an encapsulating layer, but a slight coloring was observed despite the fact that the thin film transfer layer was extremely thin.

Next, as with Example 1, the simple evaluation regarding adequacy as a substrate for AlN epitaxial growth was performed on the above-described substrate. More specifically, 2 um of AlN was deposited on the substrate for AlN epitaxial growth using the MOCVD method, and in order to evaluate the dislocation density, the EPD was measured by using the molten alkali (KOH + NaOH) etching method. In addition, XRC measurements were performed to evaluate the crystallinity. As a result, the EPD showed an extremely high dislocation density of 9.4 × 10⁸ cm⁻². In addition, the FWHM of the 0002 XRC was 1500 arcsec, resulting in a low-quality AlN single crystal. This is considered to be because the impurity concentration in the AlN single crystal was high, the coloring occurred, and the dislocation density was high due to the effect of the coloring, and also the crystallinity was not of good quality.

### Example 3

The same conditions as in Example 1 were used except for the point that the first planarizing layer was changed from SiO₂ with a thickness of 2 µm to AlAs with a thickness of 1 um. As a result, a substrate for AlN epitaxial growth was obtained, in which a 2 µm thick AlAs first planarizing layer and a 0.4 µm thick AlN seed crystal layer are provided on the supporting substrate having the structure of (1) an AlN ceramics core and (2) an encapsulating layer. 50 mm of AlN was further laminated on this AlN epitaxial growth substrate by using the HVPE method. The laminate was immersed in a 25% HCl aqueous solution to dissolve the AlAs layer and separate the 50 mm AlN crystal from the supporting substrate. Cylindrical grinding, slicing, and polishing of this AlN crystal resulted in 50 solid ϕ 2-inch AlN single crystal substrates.

Next, the same simple evaluation as that in Example 1 regarding adequacy as a substrate for AlN epitaxial growth was performed on the above-described substrate. As a result, the EPD showed an extremely low dislocation density of 1.8 × 10⁴ cm⁻². In addition, the FWHM of the 0002 XRC was 203 arcsec, resulting in a high-quality AlN single crystal. Further, no coloring was observed, and the light transmissibility at the 230 nm wavelength was good at about 95%, making it suitable as a device substrate for the deep ultraviolet range.

### Example 4

Using a method similar to that in Example 1, a supporting substrate having the structure of (1) an AlN ceramics core and (2) an encapsulating layer was prepared, and a first planarizing layer was formed on this supporting substrate. In addition, an AlN crystal to be used as a seed crystal was prepared by using a method similar to that in Example 1.

A 2 um thick SiO₂ was laminated on the AlN single crystal substrate by using the plasma CVD method (ICP-CVD equipment). After that, a second planarizing layer having a surface roughness of Ra = 0.2 nm was obtained by polishing and planarizing the SiO₂ to a thickness of 0.5 um by CMP polishing after baking the SiO₂ at 1000°C.

Ion implantation of hydrogen was carried out on the surface of the AlN single crystal substrate on which the second planarizing layer was laminated at 100 keV, at a depth of 0.6 µm (peeling position), and with a dose of 8 × 10¹⁷ cm⁻². After the ion implantation, the second planarizing layer formed on the AlN single crystal substrate was bonded with the planarizing layer of the supporting substrate prepared earlier. After that, the seed crystal layer of the AlN single crystal was transferred to the supporting substrate by peeling and separation at the peeling position (section at 0.6 µm). The section of the AlN single crystal in the seed crystal layer, which was damaged during ion implantation and transfer, was lightly polished with CMP, and the thickness of the AlN crystal layer was set to 0.4 µm. The light transmissibility of the 230 nm wavelength at this seed crystal layer was 99.9%. It should be noted that, when measuring the light transmissibility of the seed crystal layer, it was not possible to measure the transmissibility while the seed crystal layer was still transferred on the supporting substrate because the supporting substrate was opaque. Therefore, the light transmissibility was separately confirmed by instead using a seed crystal layer transferred on a quartz substrate under the same conditions. The remaining section of the AlN single crystal substrate after the transfer (i.e., the section that was peeled and separated without being transferred to the supporting substrate) could be utilized as multiple seed crystals by repeatedly carrying out ion implantation, making it extremely economical. According to the present implementation, a substrate for AlN epitaxial growth was obtained, in which a 2 µm thick planarizing layer and a 0.4 µm thick AlN seed crystal layer were provided on the supporting substrate having the structure of (1) an AlN ceramics core and (2) an encapsulating layer.

### (Evaluation of Substrate)

Next, the following simple evaluation regarding adequacy as a substrate for AlN epitaxial growth was further performed on the above-described substrate. More specifically, 2 µm of AlN was deposited on the substrate for AlN epitaxial growth using the MOCVD method, and in order to evaluate the dislocation density, the etch pit density (hereinafter referred to as "EPD") was measured by generating etch pitches by the molten alkali (KOH + NaOH) etching method. In addition, X-ray rocking curve (XRC) measurements were performed to evaluate the crystallinity. As a result, the EPD showed an extremely low dislocation density of 1.2 × 10⁴ cm⁻². The XRC measurements on a (0002) plane of the substrate yielded a half-value width FWHM of 187 arcsec, resulting in a high-quality AlN single crystal. These results indicate that the substrate for epitaxial growth according to the present example is superior.

As described above, according to the present invention, a substrate for group III nitride epitaxial growth, which is capable of fabricating a high-quality group III nitride single crystal, can be provided at low cost.

### REFERENCE SIGNS LIST

- 1, 1A: Composite substrate
- 2: Seed crystal layer
- 3: Supporting substrate
- 4: First planarizing layer
- 5: Stress adjusting layer
- 20: Single crystal substrate of group III nitride
- 21: Peeling position
- 22: Base substrate
- 23: Epitaxial layer
- 24: Second planarizing layer

## Claims

1. A substrate for group III nitride epitaxial growth comprising:
a supporting substrate having a structure in which a core consisting of nitride ceramics is wrapped in an encapsulating layer having a thickness of between 0.05 µm and 1.5 µm, inclusive;
a first planarizing layer provided on an upper surface of the supporting substrate, the first planarizing layer having a thickness of between 0.5 µm and 3.0 µm, inclusive; and
a seed crystal layer consisting of a single crystal of a group III nitride, the seed crystal layer being provided on an upper surface of the first planarizing layer and having a thickness of between 0.1 µm and 1.5 µm, inclusive.

2. A substrate for group III nitride epitaxial growth comprising:
a supporting substrate having a structure in which a core consisting of nitride ceramics is wrapped in an encapsulating layer having a thickness of between 0.05 µm and 1.5 um, inclusive;
a first planarizing layer provided on an upper surface of the supporting substrate, the first planarizing layer having a thickness of between 0.5 µm and 3.0 µm, inclusive;
a second planarizing layer provided on an upper surface of the first planarizing layer, the second planarizing layer having a thickness of 0.5 µm or less; and
a seed crystal layer consisting of a single crystal of a group III nitride, the seed crystal layer being provided on an upper surface of the second planarizing layer and having a thickness of between 0.1 µm and 1.5 µm, inclusive.

3. The substrate for group III nitride epitaxial growth according to claim 2, wherein the second planarizing layer contains any one of silicon oxide, silicon oxynitride, and aluminum arsenide.

4. The substrate for group III nitride epitaxial growth according to any one of claims 1 to 3, wherein the substrate further comprises a stress adjusting layer on a bottom surface of the supporting substrate.

5. The substrate for group III nitride epitaxial growth according to any one of claims 1 to 4, wherein the core is aluminum nitride ceramics.

6. The substrate for group III nitride epitaxial growth according to any one of claims 1 to 5, wherein the encapsulating layer contains silicon nitride.

7. The substrate for group III nitride epitaxial growth according to any one of claims 1 to 6, wherein the first planarizing layer contains any one of silicon oxide, silicon oxynitride, and aluminum arsenide.

8. The substrate for group III nitride epitaxial growth according to any one of claims 1 to 7, wherein the seed crystal layer is aluminum nitride or aluminum gallium nitride.

9. The substrate for group III nitride epitaxial growth according to any one of claims 1 to 8, wherein light transmissibility of the seed crystal layer at a wavelength of 230 nm is 70% or more.

10. The substrate for group III nitride epitaxial growth according to any one of claims 1 to 9, wherein resistivity of the seed crystal layer is 1 × 10⁶ Ωcm or more.

11. The substrate for group III nitride epitaxial growth according to claim 4, wherein the stress adjusting layer contains simple substance silicon.

12. A method for producing a substrate for group III nitride epitaxial growth, the method comprising the steps of:
preparing a core consisting of nitride ceramics;
obtaining a supporting substrate by depositing an encapsulating layer so as to wrap the core, the encapsulating layer having a thickness of between 0.05 µm and 1.5 um, inclusive;
depositing a first planarizing layer on an upper surface of the supporting substrate, the first planarizing layer having a thickness of between 0.5 µm and 3.0 um, inclusive; and
providing a seed crystal layer consisting of a single crystal of a group III nitride on an upper surface of the first planarizing layer, the seed crystal layer having a thickness of between 0.1 µm and 1.5 µm, inclusive.

13. The method for producing a substrate for group III nitride epitaxial growth according to claim 12, wherein the step of providing the seed crystal layer includes the steps of:
preparing a single crystal substrate of a group III nitride, one surface of the single crystal substrate being an ion implantation surface;
forming a peeling position in the single crystal substrate by performing ion implantation from the ion implantation surface;
obtaining a bonded substrate by bonding the ion implantation surface and the first planarizing layer; and
separating the bonded substrate into the seed crystal layer and a remaining section of the single crystal substrate at the peeling position.

14. A method for producing a substrate for group III nitride epitaxial growth, the method comprising the steps of:
preparing a core consisting of nitride ceramics;
obtaining a supporting substrate by depositing an encapsulating layer so as to wrap the core, the encapsulating layer having a thickness of between 0.05 um and 1.5 µm, inclusive;
depositing a first planarizing layer on an upper surface of the supporting substrate, the first planarizing layer having a thickness of between 0.5 µm and 3.0 µm, inclusive; and
preparing a single crystal substrate of a group III nitride, one surface of the single crystal substrate being an ion implantation surface;
forming a peeling position in the single crystal substrate by performing ion implantation from the ion implantation surface;
prior to or after the step of forming the peeling position, depositing a second planarizing layer on an upper surface of the ion implantation surface of the single crystal substrate, the second planarizing layer having a thickness of 0.5 um or less;
obtaining a bonded substrate by bonding the second planarizing layer and the first planarizing layer; and
forming a seed crystal layer consisting of a single crystal of a group III nitride by separating the bonded substrate at the peeling position to remove a remaining section of the single crystal substrate, the seed crystal layer having a thickness of between 0.1 µm and 1.5 um, inclusive.

15. The method for producing a substrate for group III nitride epitaxial growth according to claim 14, wherein the second planarizing layer is deposited by using any one of a plasma CVD method, an LPCVD method, and a low-pressure MOCVD method.

16. The method for producing a group III nitride epitaxial growth according to claim 14 or 15, wherein the second planarizing layer contains any one of silicon oxide, silicon oxynitride, and aluminum arsenide.

17. The method for producing a substrate for group III nitride epitaxial growth according to any one of claims 13 to 16, wherein, in the step of preparing the single crystal substrate, the single crystal substrate is fabricated by using a sublimation method.

18. The method for producing a substrate for group III nitride epitaxial growth according to any one of claims 13 to 17, wherein, in the step of preparing the single crystal substrate, the single crystal substrate is obtained by epitaxially growing an epitaxial layer on a base substrate by using any one of an MOCVD method, an HVPE method, and a THVPE method.

19. The method for producing a group III nitride epitaxial growth according to claim 18, wherein, in the step of forming the peeling position, the peeling position is formed within the epitaxial layer.

20. The method for producing a substrate for group III nitride epitaxial growth according to claim 18 or 19, wherein the base substrate is fabricated by using a sublimation method.

21. The method for producing a substrate for group III nitride epitaxial growth according to claim 18 or 19, wherein the remaining section of the single crystal substrate is reused as the base substrate.

22. The method for producing a substrate for group III nitride epitaxial growth according to any one of claims 13 to 21, wherein the remaining section of the single crystal substrate is reused as a single crystal substrate in production of a further different group III nitride composite substrate.

23. The method for producing a substrate for group III nitride epitaxial growth according to any one of claims 12 to 22, wherein the method further comprises a step of depositing a stress adjusting layer on a bottom surface of the supporting substrate.

24. The method for producing a substrate for group III nitride epitaxial growth according to any one of claims 12 to 23, wherein the encapsulating layer is deposited by using an LPCVD method.

25. The method for producing a substrate for group III nitride epitaxial growth according to any one of claims 12 to 24, wherein the first planarizing layer is deposited by using any one of a plasma CVD method, an LPCVD method, and a low-pressure MOCVD method.

26. The method for producing a substrate for group III nitride epitaxial growth according to any one of claims 12 to 25, wherein the core is aluminum nitride ceramics.

27. The method for producing a substrate for group III nitride epitaxial growth according to any one of claims 12 to 26, wherein the encapsulating layer contains silicon nitride.

28. The method for producing a substrate for group III nitride epitaxial growth according to any one of claims 12 to 27, wherein the first planarizing layer contains any one of silicon oxide, silicon oxynitride, and aluminum arsenide.

29. The method for producing a substrate for group III nitride epitaxial growth according to any one of claims 12 to 28, wherein the seed crystal layer is aluminum nitride or aluminum gallium nitride.

30. The method for producing a substrate for group III nitride epitaxial growth according to any one of claims 12 to 29, wherein light transmissibility of the seed crystal layer at a wavelength of 230 nm is 70% or more.

31. The method for producing a substrate for group III nitride epitaxial growth according to any one of claims 12 to 30, wherein resistivity of the seed crystal layer is 1 × 10⁶ Ωcm or more.

32. The method for producing a substrate for group III nitride epitaxial growth according to claim 23, wherein the stress adjusting layer contains simple substance silicon.
